# EUROPEAN PATENT SPECIFICATION

(11) **EP 2 832 479 B1**
(45) Date of publication and mention of the grant of the patent: **13.07.2016**
(21) Application number: 12873015.7
(22) Date of filing: 29.03.2012
(51) Int. Cl.: C23C 14/00, C23C 14/06, C23C 14/16, C23C 14/34, C23C 28/00

(54) **HARD COATING FOR CUTTING TOOL AND CUTTING TOOL COATED WITH HARD COATING**
HARTBESCHICHTUNG FÜR EIN SCHNEIDWERKZEUG UND MIT DER HARTBESCHICHTUNG BESCHICHTETES SCHNEIDWERKZEUG
REVÊTEMENT DUR POUR OUTIL DE COUPE ET OUTIL DE COUPE RECOUVERT D'UN REVÊTEMENT DUR

(43) Date of publication of application: 04.02.2015
(73) Proprietor: OSG Corporation, Aichi 442-0005 (JP)
(72) Inventor: SAKURAI Masatoshi, Toyokawa-shi Aichi 442-0005 (JP); MURASAWA Kouki, Toyokawa-shi Aichi 442-0005 (JP)
(74) Representative: TBK
(86) International application number: PCT/JP2012/058450
(87) International publication number: WO 2013/145233

(56) References cited:
- EP-A2- 1 552 036
- JP-A- 2000 178 720
- JP-A- 2008 173 756
- JP-A- 2011 240 438
- US-A1- 2006 222 893
- J. M. CASTANHO ET AL: "Towards an improvement of performance of TiAlN hard coatings using metal interlayers", MRS PROCEEDINGS, vol. 750, 1 January 2002 (2002-01-01), XP055216278, DOI: 10.1557/PROC-750-Y5.18

## Description

### TECHNICAL FIELD

The present invention relates to a cutting tool hard film disposed as coating on a surface of a cutting tool and a hard film coated cutting tool provided with the hard film and particularly to an improvement for increasing both abrasion resistance and welding resistance.

### BACKGROUND ART

Cutting tools such as drills and taps are provided and coated with a hard film to increase abrasion resistance. TiN-based, TiCN-based, TiAlN-based and AlCrN-based coatings are widely used for this cutting tool hard film and improvements are achieved for further increasing performance thereof. For example, this corresponds to a hard laminated film described in Patent Documents 1 and 2 and Non-Patent Literature 1.

### PRIOR ART DOCUMENT

### Patent Document

Patent Document 1: JP 2010-76082 A
Patent Document 2: JP 2011-240438 A
Non-Patent Literature 1: J.M. Castanho et al.: "Towards an improvement of performance of TiAlN hard coatings using metal interlayers", MRS Proceedings, vol. 750

### SUMMARY OF THE INVENTION

### Problem to Be Solved by the Invention

However, a cutting tool with a hard film formed by the conventional technique as described above may have insufficient welding resistance at the time of cutting depending on a type of work material and a cutting condition. Therefore, a tool life may be shortened due to welding of work material etc., and room for improvement exists. Therefore, it is requested to develop a cutting tool hard film and a hard film coated cutting tool excellent in both abrasion resistance and welding resistance.

The present invention was conceived in view of the situations and it is therefore an object of the present invention to provide a cutting tool hard film and a hard film coated cutting tool excellent in both abrasion resistance and welding resistance. Means for Solving the Problem

To achieve the object, the first aspect of the invention provides a cutting tool hard film disposed as coating on a surface of a cutting tool, wherein the cutting tool hard film is a multilayer film having a first film layer that is Ag, and a second film layer that is nitride, oxide, carbide, carbonitrides, or boride of Al_{1-a-b}CrₐM_{b} alternately laminated in 44 or more layers, wherein said M related to the second film layer includes at least one of Si, V, and W, wherein said atom ratio a related to the second film layer is within a range of 0.2 or more and 0.5 or less while said b is within a range larger than 0 and equal to or less than 0.3, wherein a lamination cycle of the first film layer and the second film layer is within a range of 0.2 nm or more and 100 nm or less, and wherein a total film thickness is within a range of 0.2 µm or more and 10.0 µm or less.

To achieve the object, the second aspect of the invention provides a hard film coated cutting tool having the cutting tool hard film recited in the first aspect of the invention disposed as coating on a surface.

### Effects of the Invention

As described above, according to the first aspect of the invention, the cutting tool hard film is a multilayer film having a first film layer that is Ag, and a second film layer that is nitride, oxide, carbide, carbonitrides, or boride of Al_{1-a-b}CrₐM_{b} alternately laminated in 44 or more layers, said M related to the second film layer includes at least one of Si, V, and W, said atom ratio a related to the second film layer is within a range of 0.2 or more and 0.5 or less while said b is within a range larger than 0 and equal to or less than 0.3, a lamination cycle of the first film layer and the second film layer is within a range of 0.2 nm or more and 100 nm or less, and a total film thickness is within a range of 0.2 µm or more and 10.0 µm or less. Therefore, since Ag is contained in the film, friction coefficient and cutting resistance can be reduced; and a high hardness film excellent in lubricity and welding resistance is acquired. Namely, the cutting tool hard film excellent in both abrasion resistance and welding resistance can be provided.

According to the second aspect of the invention, a hard film coated cutting tool has the cutting tool hard film recited in the first aspect of the invention disposed as coating on a surface. Therefore, since Ag is contained in the film, friction coefficient and cutting resistance can be reduced, and a high hardness film excellent in lubricity and welding resistance is acquired. Thus, the hard film coated cutting tool excellent in both abrasion resistance and welding resistance can be provided.

### BRIEF DESCRIPTION OF THE DRAWINGS

Fig. 1 is a diagram of a drill that is an embodiment of a hard film coated cutting tool of the present invention and is a front view from a direction orthogonal to an axial center.
Fig. 2 is an enlarged bottom view of the drill depicted in Fig. 1 viewed from a tip disposed with a cutting edge.
Fig. 3 is an enlarged cross-sectional view around a surface of a body of the drill of Fig. 1, exemplarily illustrating a configuration of a hard film that is an embodiment of a cutting tool hard film of the present invention.
Fig. 4 is a diagram for explaining an example of a coating method of the hard film of Fig. 3.
Fig. 5 is a diagram of coating structures of samples used in a drilling test conducted by the present inventors for verifying an effect of the present invention, and also indicates respective test results.

### MODE FOR CARRYING OUT THE INVENTION

A cutting tool hard film of the present invention is preferably applied to surface coating of various cutting tools including rotary cutting tools such as end mills, drills, face mills, forming mills, reamers, and taps, as well as non-rotary cutting tools such as tool bits. Although cemented carbide and high speed tool steel are preferably used as tool base material, i.e., material of a member provided with the hard film, other materials are also available and, for example, the cutting tool hard film of the present invention is widely applied to cutting tools made of various materials such as cermet, ceramics, polycrystalline diamond, single-crystal diamond, polycrystalline CBN, and single-crystal CBN.

The cutting tool hard film of the present invention is disposed as coating on a portion or the whole of the surface of a cutting tool and is preferably disposed on a cutting portion involved with cutting in the cutting tool. More preferably, the cutting tool hard film is disposed to coat at least a cutting edge or a rake surface in the cutting portion.

If M includes at least one of Si, V, and W, the second film layer is made of nitride, oxide, carbide, carbonitrides, or boride of Al_{1-a-b}CrₐM_{b}, or mutual solid solution thereof. Specifically, the second film layer is made of AlCrSiN, AlCrSiO, AlCrSiB, AlCrSiVN, AlCrSiWCN, AlCrSiVWB, AlCrVN, AlCrVC, AlCrVWO, AlCrWN, AlCrWCN, etc.

Film thicknesses of the first film layer and the second film layer are respectively defined depending on composition etc., and if pluralities of the layers are repeatedly laminated, the respective film thicknesses may be constant or may be changed continuously or stepwise. Although average film thicknesses of the first film layers and the second film layers vary depending on a member to be coated, composition of the film, etc., appropriate average film thicknesses are within a range of about 0.1 to 50 nm, for example.

Although the first and second film layers are preferably disposed by, for example, a PVD method such as an arc ion plating method, an ion beam deposition method, a sputtering method, a PLD (Pulse Laser Deposition) method, and an IBAD (Ion Beam Assisted Deposition) method, other film formation methods are also employable. Embodiment

A preferred embodiment of the present invention will now be described in detail with reference to the drawings. In the drawings used in the following description, portions are not necessarily precisely depicted in terms of dimension ratio, etc.

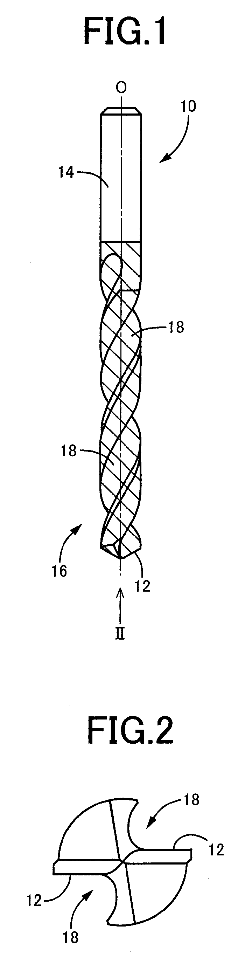

Fig. 1 is a diagram of a drill 10 that is an embodiment of a hard film coated cutting tool of the present invention and is a front view from a direction orthogonal to an axial center O. Fig. 2 is an enlarged bottom view of the drill 10 depicted in Fig. 1 viewed from a tip disposed with a cutting edge 12 (i.e., a direction indicated by an arrow II). The drill 10 of this embodiment depicted in Figs. 1 and 2 is a two-flute twist drill and integrally includes a shank 14 and a body 16 in the axial center O direction. The body 16 has a pair of flutes 18 twisted clockwise around the axial center O. The tip of the body 16 is provided with a pair of the cutting edges 12 corresponding to the pair of the flutes 18 and, when the drill 10 is rotationally driven clockwise around the axial center O in a view from the shank 14, a hole is cut in work material by the cutting edges 12 while chips generated at the time of cutting of the hole are discharged through the flutes 18 toward the shank 14.

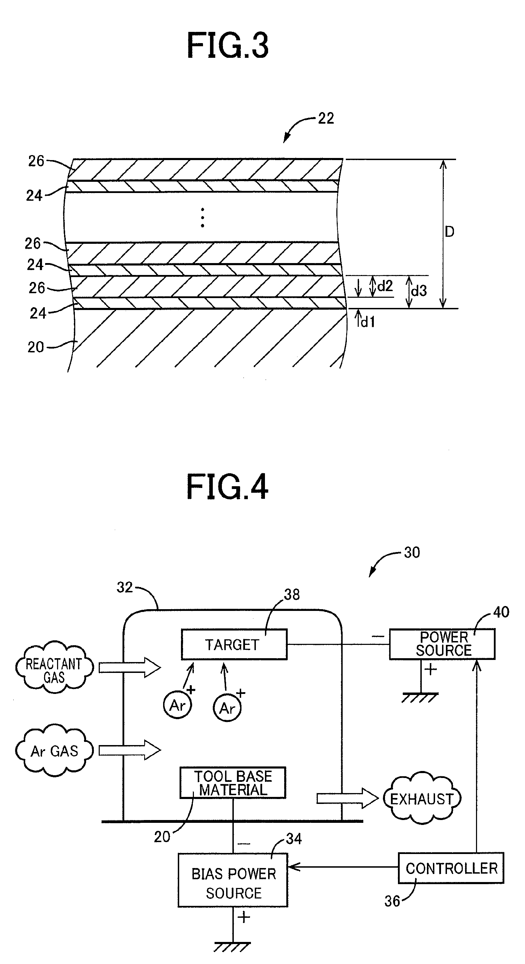

Fig. 3 is an enlarged cross-sectional view around a surface of the body 16 of the drill 10, exemplarily illustrating a configuration of a hard film 22 that is an embodiment of the cutting tool hard film of the present invention. The drill 10 is formed by coating a surface of a tool base material (tool parent material) 20 made of high speed tool steel (high-speed steel) with the hard film 22 depicted in Fig. 3. For example, as depicted in Fig. 3, the hard film 22 is a multilayer film having first film layers 24 and second film layers 26 laminated alternately in two or more layers on the surface of the tool base material 20. Fig. 3 depicts an example in which the first film layer 24 and the second film layer 26 form a lowermost layer disposed on the surface of the tool base material 20 and an uppermost layer corresponding to a surface (outer surface) of the hard film 22, respectively; however, the second film layer 26 and the first film layer 24 may form the lowermost layer and the uppermost layer, respectively.

The first film layer 24 comprises Ag containing unavoidable impurities. The second film layer 26 is made of nitride, oxide, carbide, carbonitrides, or boride of Al_{1-a-b}CrₐM_{b} containing unavoidable impurities, or mutual solid solution thereof. M includes at least one of Si, V, and W. Therefore, specifically, the second film layer 26 comprises AlCrSiN, AlCrSiO, AlCrSiB, AlCrSiVN, AlCrSiWCN, AlCrSiVWB, AlCrVN, AlCrVC, AlCrVWO, AlCrWN, AlCrWCN, etc. An atom ratio (mixed crystal ratio) a related to the second film layer 26 is within a range of 0.2 or more and 0.5 or less (0.2≤a≤0.5) and b is within a range larger than 0 and equal to or less than 0.3 (0<b≤0.3).

The hard film 22 preferably has the first film layers 24 and the second film layers 26 formed with respective predefined constant film thicknesses (average film thicknesses). Although the respective average film thicknesses of the first film layers 24 and the second film layers 26 are separately set depending on a member to be coated, composition of the film, etc., preferably, an average film thickness d1 of the first film layers 24 and an average film thickness d2 of the second film layers 26 are appropriately defined within ranges of 0.1 to 25.0 nm and 0.1 to 75.0 nm, respectively. A lamination cycle d3 of the first film layer 24 and the second film layer 26 is within a range of 0.2 nm or more and 100 nm or less. The number of laminated layers of the first film layers 24 and the second film layers 26 (the total layer number of the first film layers 24 and the second film layers 26) is preferably within a range of 44 to 6500. Therefore, the respective layer numbers of the first film layers 24 and the second film layers 26 are preferably within a range of 22 to 3250. A total film thickness D of the hard film 22 is within a range of 0.2 µm or more and 10.0 µm or less.

Fig. 4 is a diagram for explaining an example of a coating method of the hard film 22. Coating of the hard film 22 on the drill 10 etc. is performed by using, for example, a sputtering apparatus 30 as depicted in Fig. 4 under control of a controller 36. Preferably, first, in an etching process used as pretreatment, a negative bias voltage is applied by a bias power source 34 to the tool base material 20 placed in a chamber 32 of the sputtering apparatus 30. This causes positive argon ions Ar⁺ to collide with the tool base material 20 and the surface of the tool base material 20 is roughened.

In a sputtering process, for example, a constant negative bias voltage (e.g., about -50 to -60 V) is applied by a power source 40 to a target 38 such as AlCrSi making up the second film layer 26 of the hard film 22 while a constant negative bias voltage (e.g., about -100 V) is applied by the bias power source 34 to the tool base material 20 so as to cause the argon ions Ar⁺ to collide with the target 38, thereby beating out constituent material such as AlCrSi. Reactant gas such as nitrogen gas (N₂) and hydrocarbon gas (CH₄, C₂H₂) is introduced into the chamber 32 at predetermined flow rates in addition to argon gas, and nitrogen atoms N and carbon atoms C combine with AlCrSi etc. beaten out from the target 38 to form AlCrSiN etc., which are attached as the second film layer 26 etc. in the hard film 22 to the surface of the tool base material 20. Alternatively, targets may be formed for respective elementary substances such as Al, Cr, and Si, and the sputtering may be performed by using the multiple targets at the same time to form the second film layer 26 comprising AlCrSiN etc. In the sputtering step, a positive voltage may be applied to the tool base material 20. By alternately attaching the first film layer 24 and the second film layer 26 to the surface of the tool base material 20 as described above, the hard film 22 is formed on the surface of the tool base material 20.

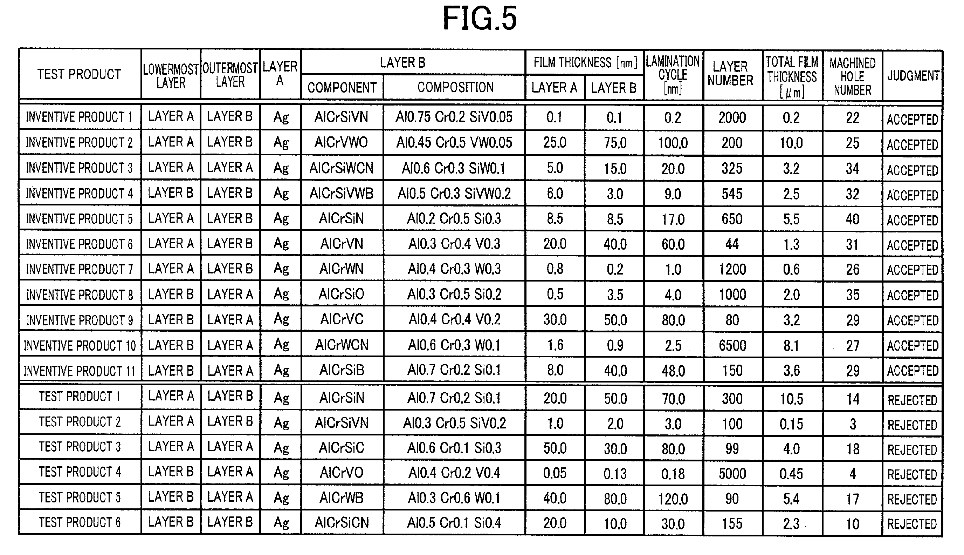

A drilling test conducted by the present inventors for verifying an effect of the present invention will then be described. Fig. 5 is a diagram of coating structures of inventive products and test products used in this test and respective test results (machined hole numbers and judgments). The present inventors created inventive products 1 to 11 and test products 1 to 6 as samples by coating cemented carbide drills having a tool diameter of 8.3 mmϕ with hard films having respective film structures and film thicknesses depicted in Fig. 5 and conducted a cutting test for each of the test products under the following cutting conditions. Out of the samples depicted in Fig. 5, the inventive products 1 to 11 correspond to inventive products to which the hard film 22 of this embodiment is applied and the test products 1 to 6 correspond to non-inventive products to which a hard film not satisfying the requirement of the present invention (out of the requirement of claim 1) is applied. "Layer A" and "Layer B" of Fig. 5 correspond to the first film layer 24 and the second film layer 26, respectively. The machined hole number depicted in Fig. 5 is the hole number when a flank wear width is 0.2 mm and an acceptance criterion is the machined hole number equal to or greater than 20 when the flank wear width is 0.2 mm.

### [Machining Conditions]

Tool shape: ϕ8.3 cemented carbide drill
Work material: Inconel (registered trademark) 718
Cutting machine: vertical type M/C
Cutting speed: 10 m/min
Feed speed: 0.1 mm/rev
Machining depth: 33mm (blind)
Step amount: non-step
Cutting oil: oil-based

As depicted in Fig. 5, all the inventive products 1 to 11 include multilayer films having the first film layers (layers A) 24 comprising Ag and the second film layers (layers B) 26 comprising nitride, oxide, carbide, carbonitrides, or boride of Al_{1-a-b}CrₐM_{b} alternately laminated in two or more layers; M related to the second film layers 26 includes at least one of Si, V, and W; the atom ratio a related to the second film layers 26 is within a range of 0.2 or more and 0.5 or less; b is within a range larger than 0 and equal to or less than 0.3; the lamination cycle d3 of the first film layer 24 and the second film layer 26 is within a range of 0.2 nm or more and 100 nm or less; and the total film thickness D is within a range of 0.2 µm or more and 10.0 µm or less. Therefore, the hard film 22 satisfying the requirement of claim 1 of the present invention is applied. As apparent from the test results depicted in Fig. 5, the acceptance criterion is satisfied by the inventive products 1 to 11 to which the hard film 22 of the embodiment is applied since all the samples have the machined hole numbers equal to or greater than 20 when the flank wear width is 0.2 mm.

Particularly, the inventive product 5 has the second film layers 26 comprising AlCrSiN (composition Al_{0.2}Cr_{0.5}Si_{0.3}), the average film thicknesses of 8.5 nm for both the first film layers 24 and the second film layers 26, the lamination cycle of 17.0 nm, the layer number of 650, and the total film thickness of 5.5 µm and results in the machined hole number of 40; the inventive product 8 has the second film layers 26 comprising AlCrSiO (composition Al_{0.3}Cr_{0.5}Si_{0.2}), the average film thickness of 0.5 nm for the first film layers 24, the average film thickness of 3.5 nm for the second film layers 26, the lamination cycle of 4.0 nm, the layer number of 1000, and the total film thickness of 2.0 µm and results in the machined hole number of 35; the inventive product 3 has the second film layers 26 comprising AlCrWCN (composition Al_{0.6}Cr_{0.3}SiW_{0.1}), the average film thickness of 5.0 nm for the first film layers 24, the average film thickness of 15.0 nm for the second film layers 26, the lamination cycle of 20.0 nm, the layer number of 325, and the total film thickness of 3.2 µm and results in the machined hole number of 34; the inventive product 4 has the second film layers 26 comprising AlCrSiVWB (composition Al_{0.5}Cr_{0.3}SiVW_{0.2}), the average film thickness of 6.0 nm for the first film layers 24, the average film thickness of 3.0 nm for the second film layers 26, the lamination cycle of 9.0 nm, the layer number of 545, and the total film thickness of 2.5 µm and results in the machined hole number of 32; the inventive product 6 has the second film layers 26 comprising AlCrVN (composition Al_{0.3}Cr_{0.4}V_{0.3}), the average film thickness of 20.0 nm for the first film layers 24, the average film thickness of 40.0 nm for the second film layers 26, the lamination cycle of 60.0 nm, the layer number of 44, and the total film thickness of 1.3 µm and results in the machined hole number of 31; and, therefore, it can be seen that these inventive products result in the machined hole numbers equal to or greater than 30 when the flank wear width is 0.2 mm and exhibit particularly favorable cutting performance.

The test product 1 has the total film thickness of 10.5 µm and deviates from the requirement of claim 1 of the present invention, i.e., the total film thickness within the range of 0.2 µm or more and 10.0 µm or less. The test product 2 has the total film thickness of 0.15 µm and deviates from the requirement of claim 1 of the present invention, i.e., the total film thickness within the range of 0.2 µm or more and 10.0 µm or less. The test product 3 has the second film layers 26 comprising AlCrSiC (composition Al_{0.6}Cr_{0.1}Si_{0.3}) and deviates from the requirement of claim 1 of the present invention, i.e., the atom ratio a of Cr within a range of 0.2 or more and 0.5 or less. The test product 4 has the second film layers 26 comprising AlCrVO (composition Al_{0.4}Cr_{0.2}V_{0.4}) and deviates from the requirement of claim 1 of the present invention, i.e., the atom ratio b of M (=V) within a range larger than 0 and equal to or less than 0.3, and has the lamination cycle of 0.18 nm and deviates from the requirement of claim 1 of the present invention, i.e., the lamination cycle within a range of 0.2 nm or more and 100 nm or less. The test product 5 has the lamination cycle of 120.0 nm and deviates from the requirement of claim 1 of the present invention, i.e., the lamination cycle within a range of 0.2 nm or more and 100 nm or less. The test product 6 has the second film layers 26 comprising AlCrSiC (composition Al_{0.5}Cr_{0.1}Si_{0.4}) and deviates from the requirement of claim 1 of the present invention, i.e., the atom ratio a of Cr within a range of 0.2 or more and 0.5 or less. As apparent from the test results depicted in Fig. 5, it can be seen that all the test products 1 to 6 have the machined hole numbers less than 20 when the flank wear width is 0.2 mm and are inferior in cutting performance to the inventive products 1 to 11. It is considered that this is because a hard film not satisfying the requirement of claim 1 of the present invention has insufficient welding resistance and reaches the end of life earlier due to welding, peeling, etc.

As described above, this embodiment provides a multilayer film having the first film layers 24 comprising Ag and the second film layers 26 comprising nitride, oxide, carbide, carbonitrides, or boride of Al_{1-a-b}CrₐM_{b} alternately laminated in two or more layers; M related to the second film layers 26 includes at least one of Si, V, and W; the atom ratio a related to the second film layers 26 is within a range of 0.2 or more and 0.5 or less; b is within a range larger than 0 and equal to or less than 0.3; the lamination cycle d3 of the first film layer 24 and the second film layer 26 is within a range of 0.2 nm or more and 100 nm or less; and the total film thickness D is within a range of 0.2 µm or more and 10.0 µm or less; therefore, since Ag is contained in the film, friction coefficient and cutting resistance can be reduced; and a high hardness film excellent in lubricity and welding resistance can be provided. Therefore, the cutting tool hard film 22 excellent in both abrasion resistance and welding resistance can be provided.

This embodiment provides the drill 10 as an ultra-hard film coated cutting tool having the hard film 22 disposed as coating on a surface and, therefore, since Ag is contained in the film, friction coefficient and cutting resistance can be reduced, and a high hardness film excellent in lubricity and welding resistance is acquired. Thus, the drill 10 excellent in both abrasion resistance and welding resistance can be provided.

Although the preferred embodiment of the present invention has been described in detail with reference to the drawings, the present invention is not limited thereto and is implemented with various modifications applied within a range not departing from the spirit thereof.

### NOMENCLATURE OF ELEMENTS

10: drill (hard film coated cutting tool) 12: cutting edge 14: shank 16: body 18: flutes 20: tool base material 22: hard film (cutting tool hard film) 24: first film layer 26: second film layer 30: sputtering apparatus 32: chamber 34: bias power source 36: controller 38: target 40: power source

## Claims

1. A cutting tool hard film (22) disposed as coating on a surface of a cutting tool, wherein
the cutting tool hard film is a multilayer film having
a first film layer (24) that is Ag, and
a second film layer (26) that is nitride, oxide, carbide, carbonitrides, or boride of Al_{1-a-b}CrₐM_{b} alternately laminated in 44 or more layers, wherein
said M related to the second film layer includes at least one of Si, V, and W, wherein
said atom ratio a related to the second film layer is within a range of 0.2 or more and 0.5 or less while said b is within a range larger than 0 and equal to or less than 0.3, wherein
a lamination cycle (d3) of the first film layer and the second film layer is within a range of 0.2 nm or more and 100 nm or less, and wherein
a total film thickness (D) is within a range of 0.2 µm or more and 10.0 µm or less.

2. A hard film coated cutting tool (10) having the cutting tool hard film of claim 1 disposed as coating on a surface.

## Patentansprüche

1. Schneidwerkzeug-Hartschicht (22), die als Beschichtung auf einer Oberfläche eines Schneidwerkzeugs angeordnet ist, wobei
die Schneidwerkzeug-Hartschicht eine mehrlagige Schicht ist, die eine erste Schichtlage (24), die Ag ist, und
eine zweite Schichtlage (26), die Nitrid, Oxid, Carbid, Carbonitrid oder Borid von Al_{1-a-b}CrₐM_{b} ist, abwechselnd in 44 oder mehr Lagen aufeinander geschichtet hat, wobei
das mit der zweiten Schichtlage zusammenhängende M zumindest eines von Si, V und W einschließt, wobei
das mit der zweiten Schichtlage zusammenhängende Atomverhältnis a in einem Bereich von 0,2 oder mehr und 0,5 oder weniger liegt, während das b in einem Bereich von größer als 0 und kleiner oder gleich 0,3 liegt, wobei
ein Aufschichtungszyklus (d3) der ersten Schichtlage und der zweiten Schichtlage in einem Bereich von 0,2 nm oder mehr und 100 nm oder weniger liegt und wobei
eine Gesamtschichtdicke (D) in einem Beriech von 0,2 µm oder mehr und 10,0 µm oder weniger liegt.

2. Mit Hartschicht beschichtetes Schneidwerkzeug (10), das auf einer Oberfläche die Schneidwerkzeug-Hartschicht von Anspruch 1 als Beschichtung angeordnet hat.

## Revendications

1. Film dur (22) d'outil de coupe disposé comme revêtement sur une surface d'un outil de coupe, dans lequel,
le film dur d'outil de coupe est un film multicouche ayant
une première couche (24) de film qui est en AG, et
une deuxième couche (26) de film qui est en nitrure, oxyde, carbure, carbonitrures, ou borure de Al_{1-a-b}CRₐM_{b}, stratifié de manière alternative en 44 couches ou plus, dans lequel
ledit M lié à la deuxième couche de film inclut au moins un de Si, V, et W, dans lequel
ledit rapport atomique a lié à la deuxième couche de film est dans une plage comprise entre 0,2 ou plus et 0,5 ou moins tandis que ledit b est dans une plage supérieure à 0 et inférieure ou égale à 0,3, dans lequel
un cycle de laminage (d3) de la première couche de film et la deuxième couche de film est dans une plage comprise entre 0,2 nm ou plus et 100 nm ou moins, et dans lequel
une épaisseur totale de film (D) est dans une plage comprise entre 0,2 µm ou plus et 10,0 µm ou moins.

2. Outil de coupe (10) recouvert d'un film dur ayant le film dur (22) d'outil de coupe de la revendication 1 disposé comme revêtement sur une surface.
